## Europäisches Patentamt
## European Patent Office
## Office européen des brevets

(11) Publication number: **0 033 358**
**B1**

(12)

# EUROPEAN PATENT SPECIFICATION

(45) Date of publication of patent specification: **03.07.85**

(51) Int. Cl.⁴: **H 01 L 39/24**

(21) Application number: **80105777.9**

(22) Date of filing: **25.09.80**

(54) **Process for fabricating thin metal superconducting films of improved thermal cyclability and device.**

(30) Priority: **01.02.80 US 117790**

(43) Date of publication of application:
**12.08.81 Bulletin 81/32**

(45) Publication of the grant of the patent:
**03.07.85 Bulletin 85/27**

(84) Designated Contracting States:
**DE FR GB**

(56) References cited:
**US-A-3 999 203**
**US-A-4 012 756**

**ZEITSCHRIFT FÜR PHYSIK B, vol. 26, no. 2, 02-04-1977, pages 161-167, Berlin, DE.**
**IBM TECHNICAL DISCLOSURE BULLETIN, vol. 18, no. 8, January 1976, page 2698, New York, USA**
**JOURNAL OF APPLIED PHYSICS, vol. 49, no. 5, May 1978, pages 2880-2884, New York, USA**

(73) Proprietor: **International Business Machines Corporation**
**Old Orchard Road**
**Armonk, N.Y. 10504 (US)**

(72) Inventor: **Kircher, Charles John**
**2929 Saddle Ridge Drive**
**Yorktown Heights, N.Y. 10598 (US)**
Inventor: **Huang, Hung-Chang Ward**
**6 Hemlock Drive**
**Hopewell Junction, N.Y. 12533 (US)**
Inventor: **Murakami, Masanori**
**123 Emerson Court**
**Yorktown Heights, N.Y. 10598 (US)**

(74) Representative: **Schröder, Otto, Dr. Ing.**
**Säumerstrasse 4**
**CH-8803 Rüschlikon (CH)**

## Description

This invention relates to a process for fabricating thin metal superconductive films of improved thermal cyclability and to a tunnel device exhibiting Josephson tunneling current and comprising such superconductive films.

Josephson devices are well-known in the art and generally include superconducting electrodes and a tunnel barrier between the superconducting electrodes. The tunnel barrier, is commonly an oxide of the base metal of the electrode, although other materials may serve as the barrier. The tunnel barrier is extremely thin, usually from about 1 to about 10 nanometers, through which Josephson tunneling current can flow at zero voltage, with two tunneling states: a pair tunneling state in which Josephson current exists at zero junction voltage and a particle tunneling state in which current exists at a finite voltage. These devices can be used to carry out logic and memory functions.

The production of Josephson devices is generally predicted on the formation of thin films of the component metals and poses difficult problems since the devices must show good stability over repeated thermal cycling, i.e. cyclability, and the tunneling resistance must be low in order to permit high Josephson current. In particular, stability of such thin films to repeated thermal cycling has heretofore posed considerable difficulty. Devices are subjected to temperatures ranging from 350K to 4.2K during fabrication and operation which subjects them to high strain during thermal cycling due to differences in thermal expansion coefficients of the device electrode and substrate materials. This is particularly characteristic of metals such as lead which have a low melting temperature and are desirable for use as superconducting electrodes of Josephson devices. Relaxation of strain can occur readily in such materials resulting, for example, in formation of hillocks, i.e. protrusions from the metal film surface, or dislocation steps which can break through the tunnel barrier of limited thickness and cause shorts between the first (base) and second (counter) electrodes.

To avoid the problems attendant to hillock formation and reduced thermal cyclability, U.S. Patent 3,999,203 teaches the use of intermetallic compounds in the superconducting electrodes to provide suppression of strain relaxation. Thus, thin layers of lead alloys with gold and/or indium show greater stability and permit increased device thermal cyclability. The films produced by the method of this patent have average grain sizes ranging from 0.2 to 1 micron for 0.2 micron thick films.

While the foregoing approach has resulted in some improvement in the thermal cyclability of Josephson devices, there still remains the need for even further improvements which will result in Josephson devices of even greater stability, particularly stability to thermal cycling.

Improved strain behavior was observed in fine-grained lead films deposited at low substrate temperature e.g. 77K (M. Murakami, *Thin Solid Films*, Vol. 59, p. 105 (1979)). Such lead films have been used as counter electrodes for Nb/Pb tunneling junctions (U.S. Patent 3,649,356). Pure lead films deposited at 77K have a grain size of about 0.25 micron for 0.2 micron film thickness and do not have sufficient chemical or thermal cycling stability for use in lead alloy Josephson devices. Josephson devices with niobium base electrodes have about three times higher junction capacitance per unit area and thus are less favorable for high speed switching applications.

This invention provides a new method for preparing films which are suitable for producing Josephson devices of improved stability. The improved stability is reflected in the fewer failures during repeated thermal cycling over a wide range of temperature. The improved stability of the films formed in accordance with the present new process is attributable to the fine grain size of the base electrode superconductor equal to or less than 100 nm, as produced by the process of the invention.

The invention as claimed is intended to remedy the drawbacks encountered with hitherto known devices and methods of producing such devices and to meet the above cited objective.

One way of carrying out the invention is described in detail below with reference to drawings which illustrate the results accomplished and in which:

FIG. 1 is a plot of the cumulative percentage of grains in a Josephson device film having a grain size less than or equal to "g" versus grain size "g".

FIG. 2 is a plot of the percentage cumulative failures of Josephson devices versus the log of the number of thermal cycles.

All reference to grain size of the film layer components of course refers to median grain size.

The reduced grain size of the film components is realized by a preparative method which includes the steps of forming a thin layer comprised of the superconductive metal at a temperature below about 100K and a pressure of about $\leq 1.3 \times 10^{-4}$Pa ($1 \times 10^{-7}$ Torr); and forming an intermetallic compound at the grain boundaries of the superconductor to limit grain growth during warming the resulting layer to ambient temperature and during subsequent processing.

The superconducting films can be prepared using well known methods such as evaporation in vacuum or sputtering or chemical or electrochemical plating. Usually, evaporation in vacuum is employed.

The superconductive metals to be employed in the present process are well known and include, for example, lead, indium, tin, bismuth, aluminium and mercury and alloys thereof, e.g., lead-indium, lead-bismuth and lead-tin alloys. The intermetallic compound formers are also well known and include gold, palladium, platinum and magnesium which form intermetallic compounds with lead, tin, indium and bismuth. In addition, bismuth forms an intermetallic compound with lead; silver and copper with tin; silver, copper and bismuth with indium. Other intermetallic compounds can be formed by selection of suitable superconductor and intermetallic compound former.

In order to realize the benefits of this invention the superconductor, as deposited at below about 100K, must be fine-grained. In addition, some of the intermetallic compound must be formed at the grain boundaries of the superconductor to most effectively inhibit grain growth. This can be accomplished by depositing the intermetallic compound former on the superconductor and diffusing it into the grain boundaries of the superconductor so that the intermetallic compound forms at the grain boundaries before grain growth. Accordingly, the compound former should not be appreciably soluble in the superconductor, e.g. gold is insoluble in lead and forms a lead-gold intermetallic compound preferentially at the grain boundaries of lead in accordance with the present process. The diffusion of compound former and formation of the intermetallic compound occurs at a temperature lower than the temperature at which grain growth starts, i.e. recrystallization temperature as employed in this art.

The Josephson devices formed in accordance with the invention include at least the base electrode formed with the fine grain size films of the invention although preferably both the base electrode and the counter electrode can be formed of the present new fine-grain size films.

The thickness of the metallic films of the invention is normally that employed for making Josephson devices. For the formation of intermetallic compounds, the intermetallic compound former is applied in thin layers, e.g. 5 nanometer layer of gold on 100 nanometer layer of lead. In general, the amount of intermetallic compound former ranges from at least about 1 weight percent and can range up to about 20 weight percent of the superconductor depending on the choice of compound former and superconductor.

The intermetallic compound can also be introduced in preformed state by co-evaporation with the superconductor.

A more detailed description of the inclusion of intermetallic compounds in the thin films is disclosed in U.S. Patent 3,999,203.

The deposition of metallic layers to form the present new films is accomplished using standard techniques such as that described in U.S. Patent 3,113,889 and 3,649,356.

The superconductor layers produced in accordance with the invention can then be used to fabricate Josephson device components. Thus, the base electrode layers can be treated to produce the requisite barrier layer, as by oxidation of the layer surface using standard techniques, such as thermal oxidation or plasma oxidation as described in U.S. 3,849,276. A counter electrode and subsequent wiring and insulation layers can be prepared (as in U.S. Patent 3,852,795) and combined with the base electrode of the present invention to form completed Josephson devices.

The varied operative steps of the inventive process are conveniently carried out in a single apparatus such as a vacuum film-forming device such as that described in U.S. Patent 3,113,889. Alternatively, each of the operative steps can be carried out in separate vacuum reaction vessels which of course would be less efficient than the use of the single vacuum reactor, and therefore is not preferred.

Electrode substrates are cleaned prior to film deposition by a plasma oxidative treatment of the surfaces to be coated by use of an rf electrode in the presence of oxygen gas at reduced pressure. Typically, the substrate is attached to an rf electrode in a vacuum system and is cleaned using an rf oxygen glow discharge, for example at about 300V at 13 Pa (10 mT) oxygen for a period of about 10 minutes.

After cleaning, the substrates are then cooled to a temperature below 100K in an initial vacuum of about $1.3 \times 10^{-5}Pa$ ($10^{-8}$ Torr) in a typical metal film coating device where the metal films are then deposited to the desired thickness. During deposition of the metals, the partial pressures of condensible gases such as water and carbon dioxide must be maintained below about $5 \times 10^{-8}$ Torr. Following film deposition, the resulting films are warmed to ambient temperature. The films thus obtained are suitable for Josephson device fabrication.

The films are deposited onto a substrate held at a temperature below about 100K to obtain reduced grain size. It is necessary for the superconductor layer to be sufficiently thin (e.g. ≤100 nm for lead or lead-indium alloys) in order that the resultant superconductive-intermetallic compound composite have the desired grain size, i.e. ≤100 nm. Because the electrode thicknesses desired for devices are typically 0.2—0.4 microns, the superconductor is deposited in layers of ≤100 nm thicknesses separated by a thin layer of intermetallic compound former. This procedure also avoids the formation of large concentrations of intermetallic compounds adjacent to the tunnel barrier, thereby allowing Josephson junctions of good electrical quality to be obtained.

The proper selection of a compound former with a given superconductor will provide the requisite structure wherein the top and bottom surfaces will remain substantially free of intermetallic compound. A minimum of routine experimentation will identify suitable combinations of the said materials.

For example, to accomplish the aforesaid, the sequential deposition of lead, gold, lead and indium will provide a layer in which the intermetallic compound, in this case $AuIn_2$, is concentrated within the formed layer and no detectable amounts of $AuIn_2$ are present in the top surface and the resulting layer is suitable for fabricating the base electrode.

The amount of intermetallic compound former employed usually ranges from about 2% to about 10% by weight of the superconductor. The use of large amounts does not provide appreciable advantage and will tend to reduce the superconduction of the layer. The thicknesses of the resulting layer of superconductor and intermetallic compound can range from about 0.1 to about 1 micron, preferably about 0.2 to about 0.4 micron.

Using the inventive process, the films produced thereby are suitable for device fabrication. Devices produced therewith exhibited in excess of one hundred times fewer failures during repeated thermal cycling in the range of 350 to 4.2K. The improved cyclability of the present devices is due to the fine grain size ($\leq$100 nm) of the components of the metal films.

The films produced in accordance with the present process show good adhesion to the substrate and are essentially hole-free and hillock-free. The adhesion properties are enhanced by the cleaning step used to prepare the electrode substrate for metal film deposition and by avoiding the use of a noble metal intermetallic compound former (e.g., gold, platinum and palladium) as the first layer. Hole-free films are the result of minimizing the presence of condensible gases during film deposition. Hillock-free films are the result of assuring a fine grain size in the metal films and of minimizing the pressure of condensible gases during deposition.

Device base electrodes were produced employing the following procedure:

The electrode substrate is mounted on a holder in a vacuum chamber fitted with a suitable vacuum pump. The holder is an rf electrode that is provided with heating and cooling passages to permit temperature control. A vessel comprising the metal to be deposited on the substrate is provided in the vacuum chamber together with means for heating the vessel. A mask. of the desired pattern for the electrode is mounted proximate the surface of the substrate, or prepared on the substrate by photoresist techniques.

Before deposition is commenced, the chamber is evacuated to a pressure of about $2.6 \times 10^{-5}$Pa ($2 \times 10^{-8}$ Torr) and the substrate is cleaned (rf electrode 360V/2.6 Pa (10m Torr) $O_2$/10 minutes/ 24°C), after which the substrate temperature was reduced to about 77K.

The metal-containing vessels were heated to evaporate their respective metals at a controlled rate to deposit sequentially:

100 nm Pb at 3.5 nm/sec.
5 nm Au at 0.1 nm/sec.
60 nm Pb at 3.5 nm/sec.
35 nm In at 0.5 nm/sec.

The maximum pressure during deposition is $\leq 1 \times 10^{-7}$ Torr in the vaporization chamber. After about 10 minutes, the metal film was warmed to 24°C.

The electrode was then removed from the vacuum chamber after repressurizing to atmospheric pressure.

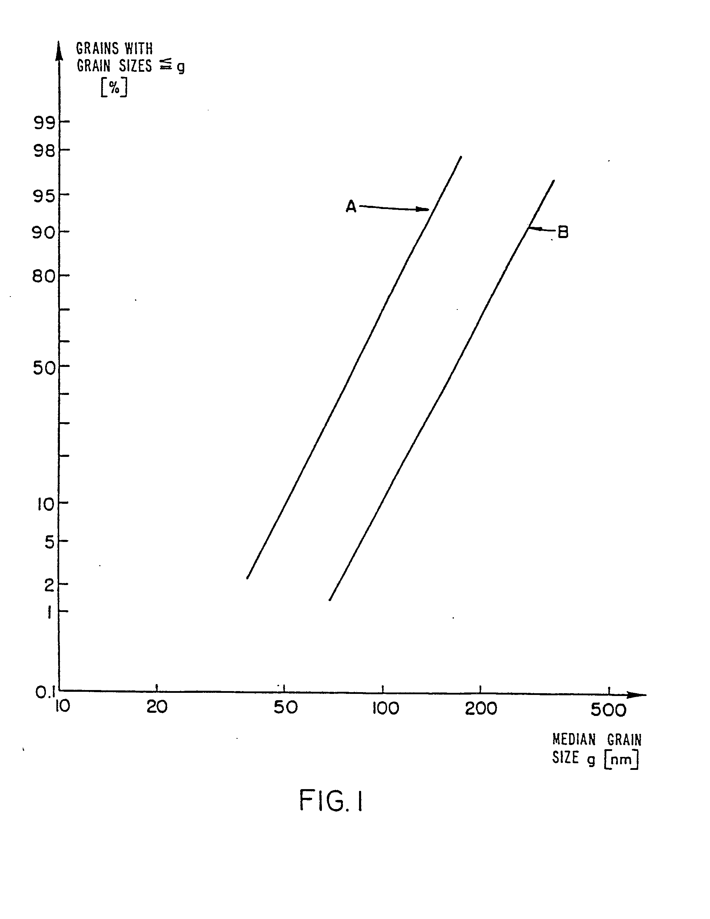

FIG. 1 of the accompanying drawings was obtained by determining the grain size of the films so produced and plotting the cumulative percentage of grains of size $\leq$"g" versus the grain size "g" expressed in nm. From these data, it is apparent that the average grain size of the present metal films is $\leq$100 nm (line A) while the average grain size of Pb-In-Au films prepared in a manner that has resulted in the best Pb-In-Au alloy Josephson junction cyclability so far obtained (S. K. Lahiri, et al., *Journal of Applied Physics*, 49 (1978) 2880) employing the teachings of U.S. Patent No. 3,999,203 is substantially above 100 nm corresponding to about 180 nm (line B).

Using the described procedure, Josephson devices were prepared and tested for stability to thermal cycling using the procedure described by S. Basavaiah and J. H. Greiner, *Journal of Applied Physics*, vol. 48, No. 11, november 1977, pp. 4630—4633.

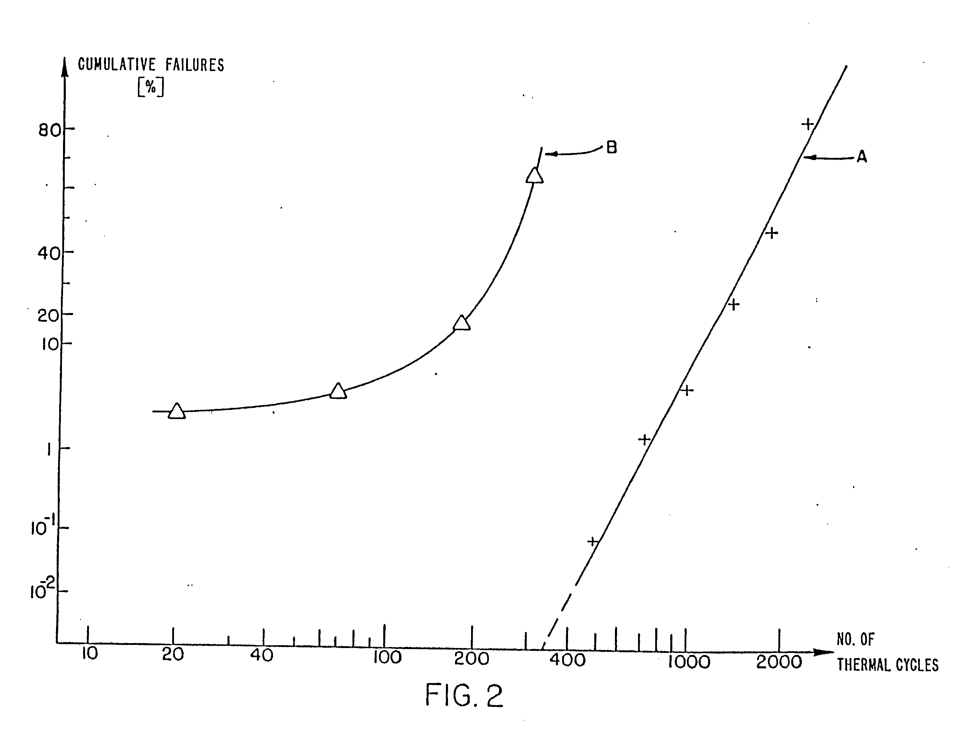

FIG. 2 of the accompanying drawings is a graph of the result obtained with Josephson devices having base electrodes prepared in accordance with the invention (curve A) in comparison with those produced according to Lahiri, et al. (curve B). The counter electrodes were 0.4 micrometer thick Pb — 29% Bi alloy for each group of junctions. In each case, wafers containing 1321 junctions per wafer were employed in the thermal cycling test described in the aforesaid literature article.

The graph plots the percent cumulative failures against the logarithm of the number of thermal cycles. As can be seen, curve A data shows a substantially higher stability for the devices produced according to the invention by a factor of at least about 100. Thus, the improvement in thermal cycling is attributed to the present process for deposition of the metal films which make up the Josephson base electrode.

The intermetallic compound, $AuIn_2$ is not present at the top surface of the film. It begins at about 30 nanometers below the top surface as determined by Auger spectroscopy and sputter-etch profiling. Thus, junctions of good electrical quality are obtained using base electrode films prepared by the inventive process.

## Claims

1. A process for fabricating thin metal superconductive films of improved thermal cyclability, characterized in that it comprises the steps of: depositing on a substrate a thin layer of at least one superconductive metal at a temperature below about 100K and a pressure below about $1.3 \times 10^{-4}$ Pa ($1 \times 10^{-7}$ Torr) to obtain a fine-grained film; and forming at the grain boundaries of the superconductor in the said layer an intermetallic compound to inhibit grain growth during warming of the resulting film layer to ambient temperature.

2. The process according to Claim 1, characterised in that the superconductive metal comprises lead or lead-indium alloy.

3. The process according to Claim 1, characterized in that the forming is accomplished by depositing a thin layer of at least one intermetallic

compound forming material on said superconductive metal.

4. The process according to Claim 3, characterized in that the intermetallic compound is comprised of gold and indium.

5. The process according to Claim 4, characterized in that the sequence of deposition of layers is lead, gold, lead and indium.

6. The process according to Claim 5, characterized in that the respective layer thicknesses of lead, gold, lead and indium are about 100, 5, 60 and 35 nm.

7. The process according to Claim 1, characterized in that the grain size of the resulting film layer if ≤100 nm.

8. A tunnel device exhibiting Josephson tunneling current, characterized in that it comprises:
a first electrode comprised of at least one superconductor and at least one intermetallic compound, said intermetallic compound being present at the grain boundaries of said superconductor, the grain size of said superconductor being ≤100 nm;
a tunnel barrier on said first electrode being sufficiently thin to permit Josephson tunneling therethrough; and
a second electrode on said tunnel barrier comprised of a superconductor.

9. The tunnel device according to Claim 8, characterized in that the superconductor comprises lead or lead-indium alloy.

10. The tunnel device according to Claim 8, characterized in that the intermetallic compound comprises gold and indium.

## Patentansprüche

1. Ein verfahren zur Herstellung eines dünnen supraleitenden Metallfilms mit verbesserten Temperaturzykluseigenschaften, gekennzeichnet durch folgende Schritte: Aufbringen einer dünnen Schicht aus wenigstens einem supraleitenden Metall auf einem Substrat bei einer Temperatur von unter etwa 100°K und einem Druck von unter etwa $1.3 \times 10^{-4}$ Pa, um einen feinkörnigen Film zu erhalten, und Bildung einer intermetallischen Verbindung an den Korngrenzen des Supraleiters der genannten Schicht, um eine Kornvergrösserung während der Erwärmung der resultierenden Filmschicht auf Umgebungstemperatur zu verhindern.

2. Verfahren nach Anspruch 1, dadurch gekennzeichnet, dass das supraleitende Metall aus Blei oder einer Blei-Indium-Legierung besteht.

3. Verfahren nach Anspruch 1, dadurch gekennzeichnet, dass zur Bildung der genannten intermetallischen Verbindung ein dünner Film aus wenigstens einem, intermetallische Verbindungen eingehenden Material auf dem supraleitenden Metall aufgebracht wird.

4. Verfahren nach Anspruch 3, dadurch gekennzeichnet dass die intermetallische Verbindung aus Gold und Indium besteht.

5. Verfahren nach Anspruch 4, dadurch gekennzeichnet, dass die Schichten in der Reihenfolge Blei, Gold, Blei, Indium aufgebracht werden.

6. Verfahren nach Anspruch 5, dadurch gekennzeichnet, dass die Blei-, Gold-, Blei- und Indium-Schichten eine Dicke von etwa 100, 5, 60 bzw. 35 nm aufweisen.

7. Verfahren nach Anspruch 1, dadurch gekennzeichnet, dass die Korngrösse der resultierenden Filmschicht ≦100 nm beträgt.

8. Eine Josephson-Tunnelstrom-Vorrichtung, dadurch gekennzeichnet, dass sie folgende Elemente aufweist:
eine erste Elektrode, die aus wenigstens einem Supraleiter und wenigstens einer intermetallischen Verbindung besteht, wobei sich die intermetallische Verbindung an den Korngrenzen des Supraleiters befindet, und die Korngrösse des Supraleiters ≦100 nm ist,
eine auf der ersten Elektrode erzeugte Tunnelbarriere, die dünn genug ist, um einen Josephson-Tunnelstrom durch die Barriere zu ermöglichen, und
eine auf der Tunnel-Barriere angeordnete zweite Elektrode, die aus einem Supraleiter besteht.

9. Vorrichtung nach Anspruch 8, dadurch gekennzeichnet, dass der Supraleiter Blei oder eine Blie-Indium-Legierung enthält.

10. Vorrichtung nach Anspruch 8, dadurch gekennzeichnet, dass die intermetallische Verbindung Gold und Indium enthält.

## Revendications

1. Procédé de fabrication de couches minces métalliques supraconductrices à stabilité améliorée pour les cycles thermiques, caractérisé en ce qu'il comprend les stades de dépôt d'une couche mince d'au moins un métal supraconducteur sur un substrat à une température inférieure à 100°K environ et sous une pression inférieure à $1,3 \times 10^{-4}$ Pa ($1 \times 10^{-7}$ Torr) afin d'obtenir une couche mince à grain fin; et formation d'un composé intermétallique aux limites de grain du supraconducteur dans cette couche afin d'empêcher la croissance du grain pendant le chauffage de la couche mince résultante à la température ambiante.

2. Procédé suivant la revendication 1, caractérisé en ce que le métal supraconducteur est constitué de plomb ou d'un alliage plomb-indium.

3. Procédé suivant la revendication 1, caractérisé en ce que la formation s'effectue par dépôt d'une couche mince d'au moins un matériau formant le composé intermétallique sur le métal supraconducteur.

4. Procédé suivant la revendication 3, caracterisé en ce que le composé intermétallique est constitué d'or et d'indium.

5. Procédé suivant la revendication 4, caractérisé en ce que le dépôt des couches se fait dans l'ordre suivant: plomb, or, plomb et indium.

6. Procédé suivant la revendication 5, caractérisé en ce que les épaisseurs des couches respectives de plomb, d'or, de plomb et d'indium sont d'environ 100, 5, 60 et 35 nm.

7. Procédé suivant la revendication 1, caractérisé en ce que la dimension des grains de la couche mince résultante est ≤100 nm.

8. Dispositif tunnel présentant un courant d'effet de tunnel de Josephson, caractérisé en ce qu'il comprend: un première électrode constituée d'au moins un supraconducteur et d'au moins un composé intermétallique, ce composé intermétallique étant présent aux limites de grain du supraconducteur, la dimension des grains de ce supraconducteur étant ≤100 nm; une barrière tunnel sur cette première électrode étant suffisamment mince pour permettre la pénétration par effet tunnel de Josephson à travers elle; et une deuxième électrode sur cette barrière tunnel constituée d'un supraconducteur.

9. Dispositif tunnel suivant la revendication 8, caractérisé en ce que le supraconducteur est constitué de plomb ou d'un alliage plomb-indium.

10. Dispositif tunnel suivant la revendication 8, caractérisé en ce que le composé intermétallique est constitué d'or et d'indium.

FIG. 1

FIG. 2